# EUROPEAN PATENT APPLICATION

(11) **EP 2 110 762 A1**
(43) Date of publication of application: **21.10.2009**
(21) Application number: 08007619.3
(22) Date of filing: 18.04.2008
(51) Int. Cl.: G06F 17/50, G06F 5/00, G05B 19/418

(54) **Digital plant structure method and system thereof**

(71) Applicant: SIEMENS AKTIENGESELLSCHAFT, 80333 München (DE)
(72) Inventor: Molfenter, Dirk, 71272 Renningen (DE); Stolper, Thilo, 90402 Nürnberg (DE); Zühlsdorf, Sören, 90419 Nürnberg (DE)

(57) **Abstract**

The invention relates to a method of exporting a digital plant structure from a CAE system to a simulation model, said digital plant structure comprising a CAD layout and a library of resources of said CAD layout, wherein said resources represent components of a plant, the method comprising the steps of: importing information from at least a CAD model of multiple CAD models into said digital plant structure; mapping said digital plant structure to said multiple CAD models, wherein at least a first resource of said digital plant structure is mapped to a second resource for each CAD model of said multiple CAD models wherein said first and said second resource describe a common component of said plant; inputting a selection of a first CAD model of said multiple CAD models; adding simulation elements from a library of simulation elements into said simulation model; mapping said simulation elements to resources on said first CAD model; importing said description of said production process into said simulation model for specifying said product flow of said simulation model and a logic of said product flow; entering updated attributes of resources of said CAD layout, wherein said resources are linked to said selected first CAD model and running said simulation.

## Description

The invention relates to a method of exporting a digital plant structure, a CAE system and a computer program product.

During the engineering workflow for the design of a digital plant structure, several computer-aided design (CAD) models and simulation models are obtained from the different design phases. These models are the result of the engineering process of each phase, and several of them will be used during the whole engineering and lifecycle time of the plant.

During the transition phase in an engineering workflow the single models are further refined and modified for adaptation to the specific domains. An original CAD model can be modified with abstract elements containing concepts of the plant construction for adaptation of the original CAD model to the real live components of the plant, where the components can be delivered from various manufacturers.

It has to be ensured that the resultant modified CAD models and simulation models are still in compliance with the plant specification. Therefore, there is a need to maintain consistent design and simulation models and to synchronize the simulation models with the updated CAD models and the CAD drawings.

### Summary

The invention provides for a method of exporting a digital plant structure from a CAE system to a simulation model, a CAE system and a computer program product as claimed in the independent claims. Embodiments of the invention are given in the dependent claims.

Embodiments of the invention relate to a method of exporting a digital plant structure from a CAE system to a simulation model, said digital plant structure comprising a CAD layout and a library of resources of said CAD layout, wherein said resources represent components of a plant, the method comprising the steps of: importing information from at least a CAD model of multiple CAD models into said digital plant structure, wherein each CAD model is part of a CAD system, wherein said information comprises: resources, type of resources, attributes of said resources and description of a production process, wherein said description describes a product flow and relationships between resources; mapping said digital plant structure to said multiple CAD models wherein at least a first resource of said digital plant structure is mapped to a second resource for each CAD model of said multiple CAD models wherein said first and said second resource describe a common component of said plant.

Embodiments of the invention further comprise inputting a selection of a first CAD model of said multiple CAD models; adding simulation elements from a library of simulation elements into said simulation model; mapping said simulation elements to resources on said first CAD model; importing said description of said production process into said simulation model for specifying said product flow of said simulation model and a logic of said product flow; entering updated attributes of resources of said CAD layout, wherein said resources are linked to said selected first CAD model; and running said simulation.

CAD as used herein refers to the use of information technology to aid or assist in the design, drafting, development or optimization of objects, products, plants and the like. CAE as used herein refers to the use of information technology in tasks such as analysis, simulation, design, manufacture, planning, diagnosis and repair of objects, products, plants and the like.

The term "simulation elements" as used herein refers to the elements in the simulation that represent the resources of the CAD models and the CAD layout. The mapping between resources of different models qualifies the resources by creating a logical link between them.

The term "product" as used herein refers to any work item that is processed, manufactured or transported in a plant.

The term "product flow" as used herein refers to the route that may take a product or a series of products among the different components of a plant. The relationships between resources describe possible physical or logical connections between the components of a plant.

In accordance with other embodiments of the invention, the course of the simulation model determines predecessor and successor relationships between resources, wherein the logic of the process determines decision taking parameters. The attributes include location, rotation, direction and size of the resources. The attributes of the resources are grouped into set of facets. One of the facets is a simulation facet. The simulation elements include information of the attributes of the simulation facet. Additional attributes may be included on digital plant structure before running the simulation, wherein the additional attributes further describe the simulation elements.

In accordance with embodiments of the invention, the digital plant structure is further exported to a programmable logical controller (PLC) code.

In accordance with embodiments of the invention, the method further comprises: generating an export file, the export file comprising:
- description of a process, wherein said description describes: resources, product flows, work pieces, and starting and ending points of said flow;
- link to a first graphical file with an image of a factory and to a second graphical files with images for all moving objects;
- attributes of said resources.

In accordance with embodiments of the invention, a user explores attributes of the simulation on the digital plant structure. The results of said simulation are reported to said digital plant structure for comparison of said simulation with said selected CAD model.

A higher level engineering system, represented in a digital plant structure including a CAD layout with resources, shows a clear relationship and links with the elements of the simulation. It also represents visually how the simulation elements describe the resources from the CAD layout. Therefore, the similarities and the differences between the simulation model and the CAD layout can be clearly highlighted. A user can also initiate further changes in the simulation model, in order to narrow down the differences with the CAD layout. Finally, it allows the user to import again the model from the simulation into the CAD layout from the higher level engineering system.

The higher level engineering system can identify, after the import process from the simulation model, if the characteristic of the resources for both systems are correct. The import process also recognizes what resources from the simulation model have been deleted and what new resources have been added. Then, the higher level engineering system can delete or add the corresponding simulation facets, or alternatively add new resources with the corresponding simulation facets.

Embodiments of the invention further comprise a transformation of coordinates said resources is completed with key elements, wherein each key elements represents a dimension of said resource. The key elements are mapped on the multiple CAD models. There are as many key elements as there are dimensions in the CAD drawing. The usage of key elements provides a transformation of the coordinates with information of different positioned resources. The simulation elements that are not qualified in the selected CAD model are transferred to the simulation plant with a transformation of coordinates.

In another aspect, the invention relates to a CAE system for exporting a digital plant structure to a simulation model, said CAE system being operable to perform in accordance with any one of the preceding embodiments.

In another aspect, the invention relates to a computer program product stored on a computer usable medium, comprising computer readable program means for causing a computer to perform a method according to any of the preceding embodiments when said program is run on said computer.

Another advantage of the embodiments is that it shows a visualization of the simulation system, when the simulation elements have been projected in a specifically selected CAD model. Another advantage of the embodiments is the possibility to create or implement elements from the simulation model into a CAD layout using the higher level engineering system. The implementation is achieved using the information obtained from a CAD model from a CAD system.

### Brief description of the drawings

In the following preferred embodiments of the invention will be described in greater detail by way of example only making reference to the drawings in which:
- FIG 1: shows a block diagram of a digital plant structure,
- FIG 2: depicts a block diagram of the two systems,
- FIG 3: shows a block diagram of the link between resources from the digital plant structure and the CAD models,
- FIG 4: shows a flow chart of the engineering workflow,
- FIG 5: shows a block diagram of a simulation model.

### Detailed description

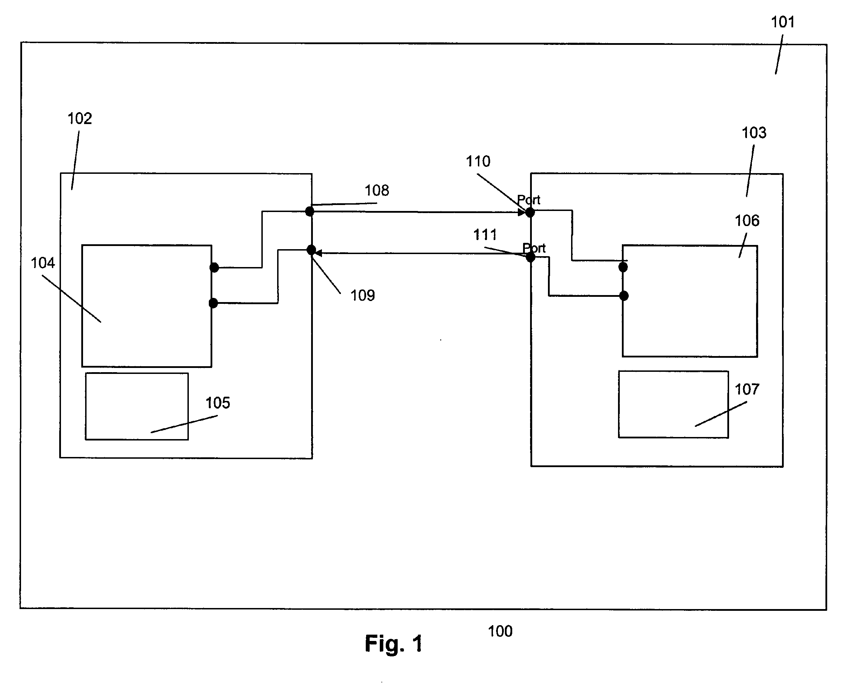

FIG 1 shows a block diagram of a digital plant structure 101 that is part of a higher level engineering system or a computer aided engineering system (CAE) including a first resource 102 and a second resource 103 that represent components of a plant. The resources are further divided by categories depending on the type of objects that represent and include one or more facet, where the first resource 102 includes a first and a third facet 104 and 105 and a second resource 103 includes a third and a fourth facet 106 and 107.

Each of the facets includes a category for each facet and a set of attributes, the category describing to what application each facet is used, as for example for simulation purposes or for programmable logical controllers. The attributes describe the characteristics of the resources for the specific application that it uses. The first resource 102 further comprises two ports 108 and 109 and the second resource includes another two ports 110 and 111. The ports are the logical links between the objects and include a category and direction, where the category can be divided into for example pieces, signals and the direction describes the route for the course of the example signals, flow etc. The direction of ports defines only what ports can be linked together. This can be used for describing route-information. The direction of a port is independent from the direction of the interfaces. Multiple interfaces are possible in only one port.

The digital plant structure is located in a higher level engineering system, as for example the Automation Designer, that includes the qualification of multiple CAD models and the components of the plant that are represented through the resources. Each resource includes the facets for the generation of the simulation model and the code for the programmable logical controller (PLC). The resources may have different qualifications on different CAD models, wherein one resource is qualified or linked with at least one resource in each CAD model of a set of CAD models.

The administration of all data that is originated from the engineering workflow are stored and kept in a resource model of a higher level engineering system that contains variable and abstraction layers that groups them altogether. The necessary information for the generation of the single models for the corresponding destination systems are grouped within each resource in facets, as shown in fig. 1. During the transition phase between the detailed and the abstraction layers, it is often necessary to update, and delete elements from the simulation system and substitute them with a plurality of specific elements.

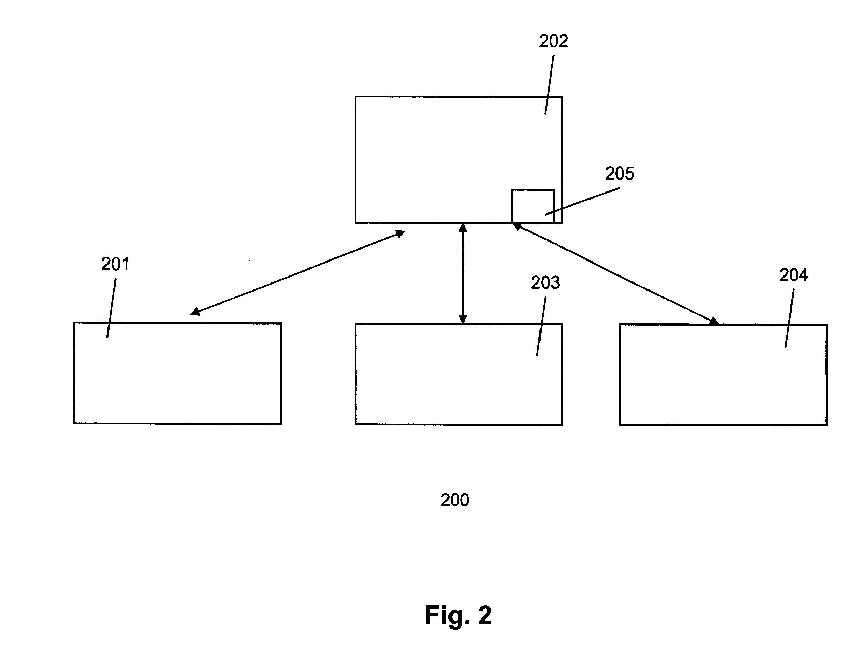

FIG 2 shows a block diagram of the main systems used during the engineering workflow process of designing, simulating and coding a plant structure. During the first designing steps of the system a first CAD model is designed on a computer aided design system 201 that represent the components of a plant into resources and describes a first concept of the plant with abstract and some more specific representations of the single components. Different CAD models can be designed as a result of the different phases of the engineering workflow. Then this CAD model is imported into a higher level engineering system 202, that can be for example a computer aided engineering system. The higher level CAE system 202 is running on a computer program product 205. The other systems 201.203 and 204 can also be running on separate or on a single computer program product.

This CAE system generates a digital plant structure as presented in fig. 1 that comprises a CAD layout and a library of resources of this CAD layout and that will interact and be used to verify and compare the differences and similarities between the different models and plants that are designed in the different phases and systems of the engineering workflow. The digital plant structure is linked to one or multiple CAD models, where at least one resource of the digital plant structure is linked with another resource of each CAD model of the multiple CAD models.

On a further step, one of these CAD models can be used to generate a simulation model into the simulation system 203. With the imported information from one of the CAD models of the CAD system 201, the simulation elements are generated for the simulation model by inserting simulation resources from a library of simulation elements. The imported information from the CAD models include the type of resources, attributes and a description of the production process, this description including a flow of a product and the flow elements. In a further step, the simulation elements of the simulation model are mapped or linked with resources of the CAD model that has been previously selected. Finally, the simulation is initiated by updating the attributes for resources of the digital plant structure, wherein these resources are linked to the CAD model. Then the full simulation is run.

It is further possible to project the generated simulation model into the previously selected CAD model, so that the consistency of the data can be proved. This allows the projection to obtain very consistent data and a visual representation of the simulation model. The higher level engineering system 202 can use this generated data to export and create a code for a programmable logical controller 204, using all the verifications and synchronization of data between all the previous systems 201-203.

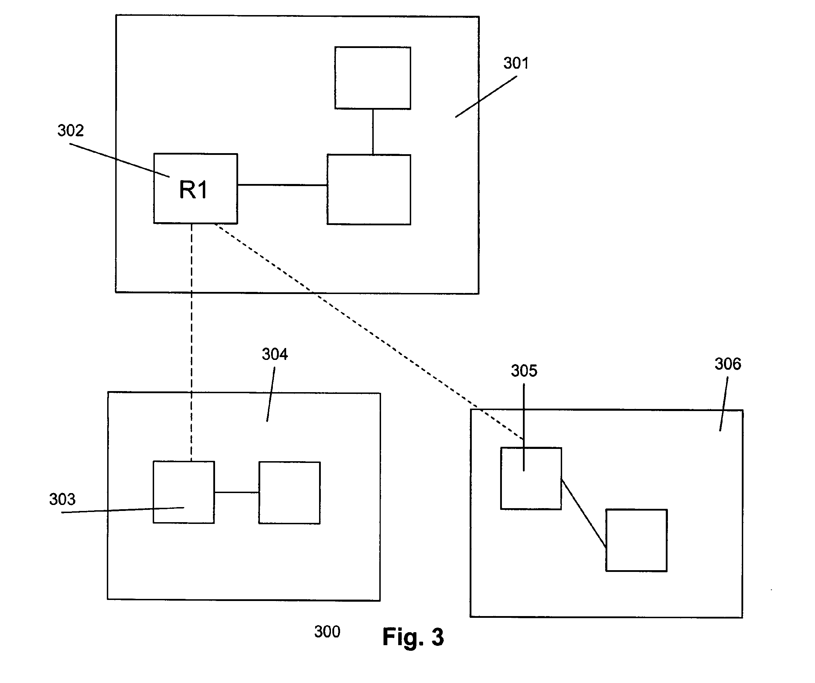

FIG 3 shows a block diagram of the link between the resources from the digital plant structure and the CAD models. The digital plant structure 301 includes a first resource 302 that is linked with a second resource 303 into a CAD model 304. Further, the same resource 302 is also linked with a third resource 305 within a second CAD model 306. The digital plant structure 301 allows a consolidation of multiple CAD models as 304 and 306 into a qualified resource structure, that includes a description of all the relevant simulation characteristics into the facets of each resource. It further allows the creation of common detailed degrees between the CAD models 304 and 306 and a simulation model. Finally, it allows the generation of simulation models into a simulation plant with a projection into a selected CAD model, allowing the flexibility of the verification and comparison of the CAD model with the simulation model.

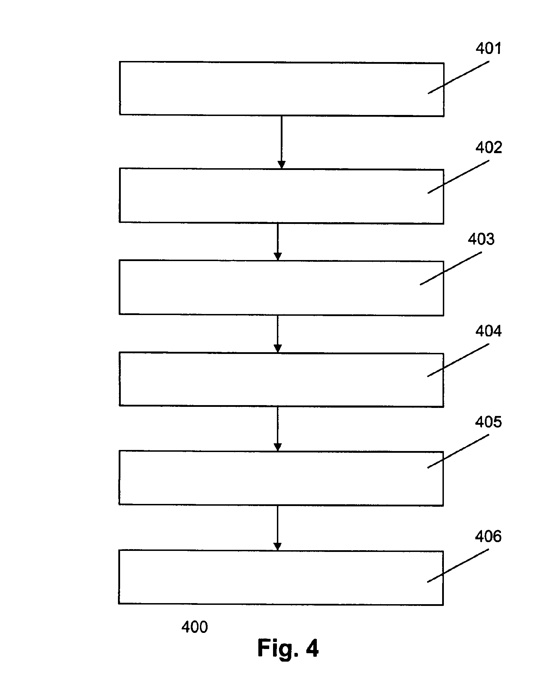

FIG 4 shows the steps followed during engineering, where a first step 401 constructs a first CAD model. This first CAD model represents a first concept of the plant with abstract objects and some more type specific representation of the components of the plant. In a second step 402, more specific and proprietary information of the manufacturers of the components is used and the abstract representation is substituted with this more specific information of the manufacturers. In the second CAD mode, some dimensions and measurements of the components of the plant do not agree with the first CAD model.

The second CAD model is imported in the higher level CAE-system, as for example the SIMATIC Automation Designer, in the step 403. The corresponding components of the plant that are represented by resources from a library of resources are qualified with the corresponding elements in the CAD model in a fourth step 404.

Subsequently, the changes made after the selection of the specific manufacturer's information are also used for the generation of the simulation model in a fifth step 405. In order to have a first overview of the changes, the simulation model is generated, based on the projection of the second CAD model in step 406. The projection of the simulation model into the new CAD model is possible, as at the most three resources, that represent the simulation objects in the new CAD model, are qualified. Less than three resources are also possible to represent the simulation objects. Then, the difference between the data from the new CAD model and the simulations can be visually observed. The iterations in the information for the simulation can be further processed in the higher level engineering system (e.g. Automation Designer), until the model of the simulation is the same as the CAD model.

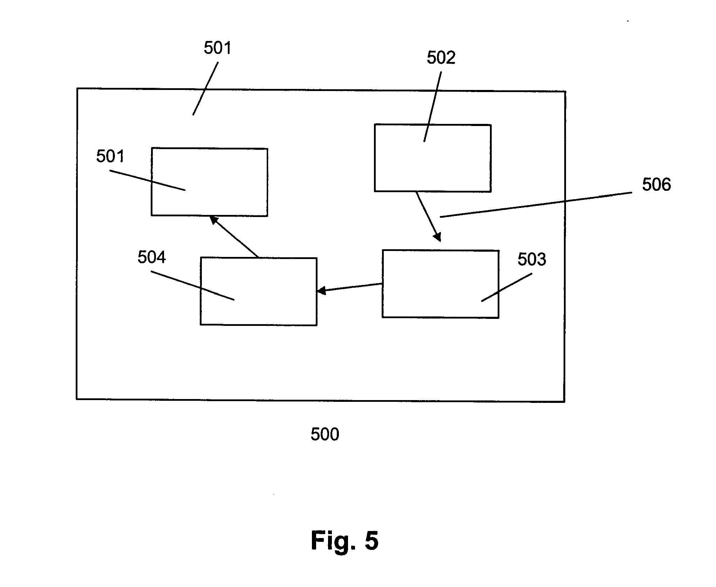

FIG 5 shows a block diagram of a simulation model that is part of the simulation system that comprises simulation elements 502, 503 and 504 and a flow of product that links all the simulation elements among each other.

The imported information from the CAD models into the digital plant structure, that includes the type of resources, the description of the production process and the attributes, is used for the generation of the simulation elements represented in fig. 5. The description of the production process determines the course of the simulation model and the logic of the process. This course describes the predecessor and successor relationship between the resources and the logic describes the decision taking parameters, that sets the boundaries and special cases when a specific product or material is flowing through the production process.

As many simulation models are a result of the dimensioning in the CAD models, it is very useful to visually compare the drawings from the plant in the simulation model with the construction of the plant in the CAD model.

Simulations systems, as for example a plant simulation systems, have an important role in creating data exchange using a CAD system, as for example factory CAD systems, over the exchange format SDX. The data exchange between the simulation system and the CAD system, the positioning of the resources and the CAD drawings are exchanged. The plant simulation uses the CAD drawings as a background image to create and correctly position the simulation elements. Originally, this data exchange could only occur between two systems, the CAD system and simulation system. It was not possible to link both applications with a higher layer computer aided engineering (CAE) system, such as the Automation Designer, and therefore no possibility of synchronization and resource validation between the different models that were created during the engineering workflow.

Through the adaption of the (CAE) system, new possibilities of data exchange and data synchronization are obtained. It is possible to synchronize two different CAD models with a common resource structure located in the higher layer engineering system, as the Automation Designer. It is further possible to create a digital plant-based structure that is qualified for all CAD models.

The generation of the simulation model by the engineering system allows synchronizing all resources for all the tools used during the engineering workflow. The projection of the generated simulation model into the CAD layout allows analyzing the consistency of the data. As a result, the projection allows a verification of the consistency of the resources and forms an intuitive representation of the simulation model.

## Claims

1. A method of exporting a digital plant structure (101) from a CAE system (202) to a simulation model, said digital plant structure (101) comprising a CAD layout and a library of resources (102-103) of said CAD layout, wherein said resources (102-103) represent components of a plant, the method comprising the steps of:
- importing information from at least a CAD model of multiple CAD models (304-306) into said digital plant structure, wherein each CAD model is part of a CAD system, wherein said information comprises: resources, type of resources, attributes of said resources and description of a production process, wherein said description describes a product flow and relationships between resources;
- mapping said digital plant structure (101) to said multiple CAD models (304-306), wherein at least a first resource (302) of said digital plant structure (301) is mapped to a second resource (303-305) for each CAD model of said multiple CAD models (304-306), wherein said first and said second resources describe a common component of said plant;
- inputting a selection of a first CAD model (304) of said multiple CAD models (304-306);
- adding simulation elements (501-504) from a library of simulation elements into said simulation model (500);
- mapping said simulation elements (501-504) to resources on said selected first CAD model (504);
- importing said description of said production process into said simulation model (500) for specifying said product flow of said simulation model and a logic of said product flow;
- entering updated attributes of resources of said CAD layout, wherein said resources are linked to said selected first CAD model (304); and
- running said simulation.

2. The method as in claim 1, wherein said relationship between resources determines predecessor and successor relationships between resources, wherein said logic of said process determines decision taking parameters.

3. The method as in any of the preceding claims, wherein said attributes include location, rotation, direction and size of said resources.

4. The method as in any of the preceding claims, wherein said attributes of said resources are grouped into set of facets (104-107),

5. The method as in claim 4, wherein said facet is a simulation facet that describes attributes used on said simulation.

6. The method as in claim 4, wherein said simulation elements include said attributes of said simulation facet.

7. The method as in any of the preceding claims, wherein additional attributes are included on said digital plant structure before running said simulation, wherein said additional attributes further describe said simulation elements.

8. The method as in any of the preceding claims, wherein said digital plant structure is further exported to a programmable logical controller (204) code.

9. The method as in any of the preceding claims, wherein the method further comprises generating an export file, said export file comprising:
- description of a process, wherein said description describes: resources, product flows, work pieces, and starting and ending points of said flow;
- link to a first graphical file with an image of a factory and to a second graphical files with images for all moving objects;
- resources and attributes of said resources.

10. The method as in any of the preceding claims, wherein a user explores attributes of said simulation on said digital plant structure.

11. The method as in any of the preceding claims, wherein results of said simulation are reported to said digital plant structure for comparison of said simulation with said selected CAD model.

12. The method as in any of the preceding claims, wherein a transformation of coordinates said resources is completed with key elements, wherein each key element represents a dimension of said resource.

13. A CAE system (202) for exporting a digital plant structure to a simulation model, said CAE system being operable to perform in accordance with any one of the preceding claims 1 to 12.

14. A computer program product (205) stored on a computer usable medium, comprising computer readable program means for causing a computer to perform a method according to any of the preceding claims 1 to 12 when said program is run on said computer.
